# EUROPEAN PATENT SPECIFICATION

(11) **EP 4 047 262 B1**
(45) Date of publication and mention of the grant of the patent: **25.02.2026**
(21) Application number: 20877035.4
(22) Date of filing: 15.10.2020
(51) Int. Cl.: F21S 2/00, F21V 9/38, F21Y 115/10, H10H 20/851

(54) **LIGHT-EMITTING DEVICE AND ILLUMINATION DEVICE**
LICHTEMITTIERENDE VORRICHTUNG UND BELEUCHTUNGSVORRICHTUNG
DISPOSITIF ÉMETTEUR DE LUMIÈRE ET DISPOSITIF D'ÉCLAIRAGE

(30) Priority: 18.10.2019 JP 2019191200
(43) Date of publication of application: 24.08.2022
(73) Proprietor: Kyocera Corporation, Kyoto-shi Kyoto 612-8501 (JP)
(72) Inventor: KUSANO,Tamio, Kyoto-shi, Kyoto 612-8501 (JP); YOKOI,Kiyotaka, Kyoto-shi, Kyoto 612-8501 (JP)
(74) Representative: Viering, Jentschura & Partner mbB Patent- und Rechtsanwälte
(86) International application number: PCT/JP2020/038942
(87) International publication number: WO 2021/075505

(56) References cited:
- WO-A1-2017/069206
- WO-A1-2019/064675
- WO-A1-2019/106864
- WO-A1-2019/163983
- CN-A- 105 716 034
- JP-A- 2016 142 525
- JP-A- 2017 212 428

## Description

### FIELD

The present invention relates to a light-emitting device and an illumination apparatus.

Recent light-emitting devices include, as light sources, semiconductor light emitters such as light-emitting diodes (LEDs) (hereafter, simply light emitters), and recent illumination apparatuses include such light-emitting devices mounted on substrates. Light from such light-emitting devices or illumination apparatuses may be used in various manufacturing processes as an alternative to natural light, such as sunlight. With the light-emitting devices or illumination apparatuses, various operations can be carried out in situations without sunlight, such as indoors or at nighttime.

These light-emitting devices or illumination apparatuses may be used for growing plants or keeping animals. For example, the light-emitting devices are nowadays used for keeping aquatic organisms, including cnidarians such as corals and sea anemones and aquatic animals such as fish, indoors. Light-emitting devices (lamps) have been developed for generating white light for this purpose, as one such example is described in Japanese Unexamined Patent Application Publication No. 2001-269104.
CN 105716034 A discloses an LED hybrid integrated light source comprising a quartz lens, a metal ring, an LED wafer body, a ceramic board and a copper substrate. The LED wafer body comprises blue-light LED wafers, white-light LED wafers, red-light LED wafers, green-light LED wafers, ultraviolet LED wafers and yellow-light LED wafers. A channel A, a channel B, a channel C and a channel D are formed by jointly combining light emitted by the blue-light LED wafers, the white-light LED wafers, the red-light LED wafers, the green-light LED wafers, the ultraviolet LED wafers and the yellow-light LED wafers.
WO 2019/064675 A1 dislcloses a light-emitting device, comprising: a light-emitting element having a light-emitting unit that emits first emission light having a first peak wavelength at 380 to 425 nm and a half-width of 15 to 35 nm; and a covering material located above the light-emitting unit of the light-emitting element, containing a phosphor emitting second emission light having a second peak wavelength at 430 to 475 nm as well as a third peak wavelength at 490 to 540 nm.
WO 2017/069206 A1 discloses an indoor light source that has a first peak in a wavelength range of 440-460nm, has a second peak in a wavelength range of 540-560nm, and has a third peak in a wavelength range of 610-630nm. Let the peak wavelength of the first peak be λ1 nm, the peak wavelength of the second peak be λ2 nm, and the peak wavelength of the third peak be λ3 nm. The indoor light source is characterized by emitting light that has an emission spectrum wherein, among the optical intensities of the first through third peaks, if the relative intensity of the greatest optical intensity is 1, the smallest optical intensity in the wavelength range λ1 - λ2 nm has a relative intensity of 0.7 or greater, and the smallest optical intensity in the wavelength range λ2 - λ3 nm has a relative intensity of 0.8 or greater.
JP 2016 142525 A discloses a light source for painted surface inspection that includes one trough peak in a wavelength region of 400-500 nm, a first crest peak on a short wavelength side of the trough peak, and a second crest peak on a long wavelength side of the trough peak. When the peak wavelength of the trough peak is assumed to be λ0 [nm], the peak wavelength of the first crest peak is assumed to be λ1 [nm], and the peak wavelength of the second crest peak is assumed to be λ2 [nm], the light source emits white light of emission spectrum of 420 nm ≤ λ0 ≤ 440 nm, 400 nm ≤ λ1 ≤ 410 nm, and 450 nm ≤ λ2 ≤ 470 nm.

However, aquatic organisms illuminated with the light-emitting devices or illumination apparatuses with the above known technique may appear to be colored differently from when they are viewed in the sea.

### BRIEF SUMMARY

The present invention provides a light-emitting device according to claim 1, and an illumination apparatus according to claim 15.

Further embodiments are described in the dependent claims.

### BRIEF DESCRIPTION OF DRAWINGS

FIG. 1 is a diagram of an example light-emitting device according to an embodiment.
FIG. 2 is a cross-sectional view of the light-emitting device taken along an imaginary plane A shown in FIG. 1.
FIG. 3 is an enlarged view of part X of the light-emitting device shown in FIG. 2.
FIG. 4 is a graph showing an example emission spectrum of the light-emitting device according to the embodiment.
FIG. 5 is a graph showing an example emission spectrum of the light-emitting device according to the embodiment.
FIG. 6 is an example perspective view of an illumination apparatus according to the embodiment.
FIG. 7 is an example exploded perspective view of the illumination apparatus according to the embodiment.
FIG. 8 is an example perspective view of the illumination apparatus according to the embodiment.
FIG. 9 is a diagram of an example illumination apparatus according to the embodiment.

### DETAILED DESCRIPTION

A light-emitting device and an illumination apparatus according to one or more embodiments of the present invention will now be described with reference to the drawings.

### Structure of Light-emitting Device

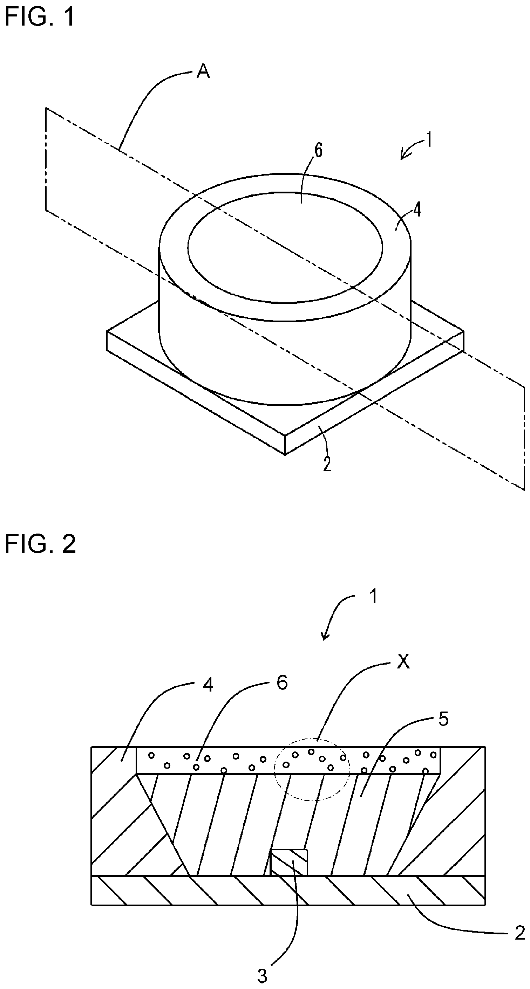

A light-emitting device 1 according to the present embodiment will now be described with reference to FIGs. 1 to 3. An illumination apparatus 10 (described later) includes one or more light-emitting devices 1.

Each light-emitting device 1 includes a component-mount board 2, a light emitter 3, a frame 4, a sealant 5, and a wavelength converter 6.

The component-mount board 2 may be formed from, for example, an insulating material. The component-mount board 2 may be formed from, for example, a ceramic material such as alumina or mullite, a glass-ceramic material, or a composite material containing two or more of these materials. The component-mount board 2 may contain a polymeric resin containing metal oxide particles being dispersed to adjust thermal expansion.

The component-mount board 2 may include, on its main surface (upper surface in the figure) or inside the component-mount board 2, a wiring conductor that electrically connects the component-mount board 2 to a wiring board 12. The wiring conductor is formed from, for example, a conductive material such as tungsten, molybdenum, manganese, or copper. The wiring conductor may be prepared by, for example, applying a metal paste containing powder of tungsten containing an organic solvent to a ceramic green sheet, which is to be the component-mount board 2, by printing in a predetermined pattern, and stacking multiple ceramic green sheets prepared in this manner on one another and firing the structure. The surface of the wiring conductor is plated with, for example, nickel or gold to prevent oxidation.

The component-mount board 2 may include a metal reflective layer spaced from the wiring conductor and the plating layer to efficiently emit light from the light emitter 3 outside. The metal reflective layer may be formed from, for example, a metal material such as aluminum, silver, gold, copper, or platinum.

In the present embodiment, multiple light emitters 3 are mounted on the main surface of the component-mount board 2. The multiple light emitters 3 are electrically connected to the plating layer on the surface of the wiring conductor on the component-mount board 2 with, for example, a brazing material or solder. Any number of light emitters 3 may be mounted on the main surface of the component-mount board 2.

The light emitters 3 may be, for example, light-emitting diodes (LEDs). An LED emits light outside when electrons and holes recombine in a p-n junction that is an interface between a p-type semiconductor and an n-type semiconductor. The light emitters 3 may be other than LEDs. For example, the light emitters 3 may be laser diodes (LDs).

Each light emitter 3 may include a light-transmissive base and an optical semiconductor layer formed on the light-transmissive base. The light-transmissive base contains, for example, a material that allows an optical semiconductor layer to grow on the light-transmissive base by chemical vapor deposition, such as metal organic chemical vapor deposition or molecular beam epitaxy. The light-transmissive base may be formed from, for example, sapphire, gallium nitride, aluminum nitride, zinc oxide, zinc selenide, silicon carbide, silicon, or zirconium boride. The light-transmissive base may have a thickness of, for example, 50 to 1000 µm inclusive.

The optical semiconductor layer may include a first semiconductor layer formed on the light-transmissive base, a light-emitting layer formed on the first semiconductor layer, and a second semiconductor layer formed on the light-emitting layer. The first semiconductor layer, the light-emitting layer, and the second semiconductor layer may be formed from, for example, a group III nitride semiconductor, a group III-V semiconductor such as gallium phosphide or gallium arsenide, or a group III nitride semiconductor such as gallium nitride, aluminum nitride, or indium nitride.

The first semiconductor layer has a thickness of, for example, 1 to 5 µm inclusive. The light-emitting layer has a thickness of, for example, 25 to 150 nm inclusive. The second semiconductor layer has a thickness of, for example, 50 to 600 nm inclusive.

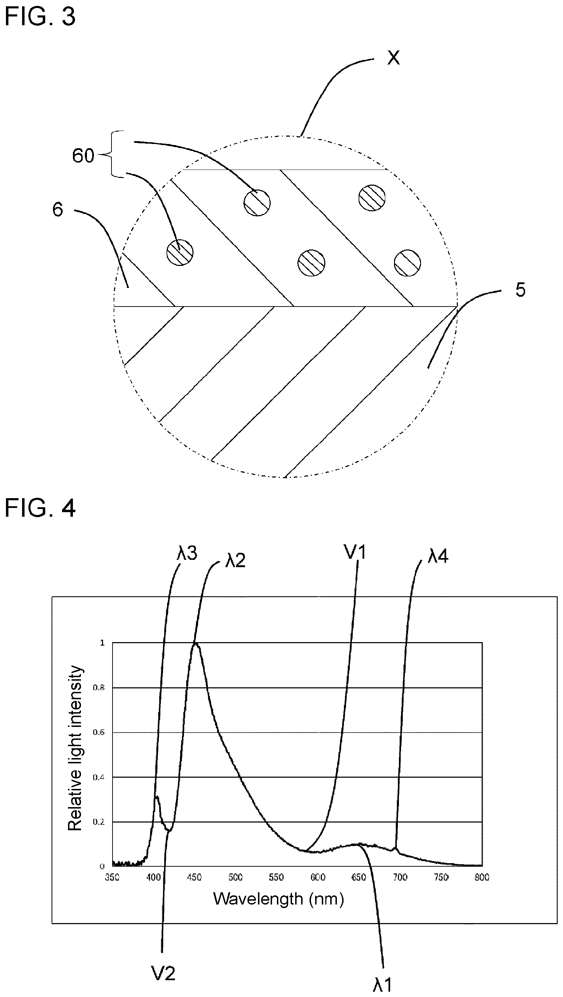

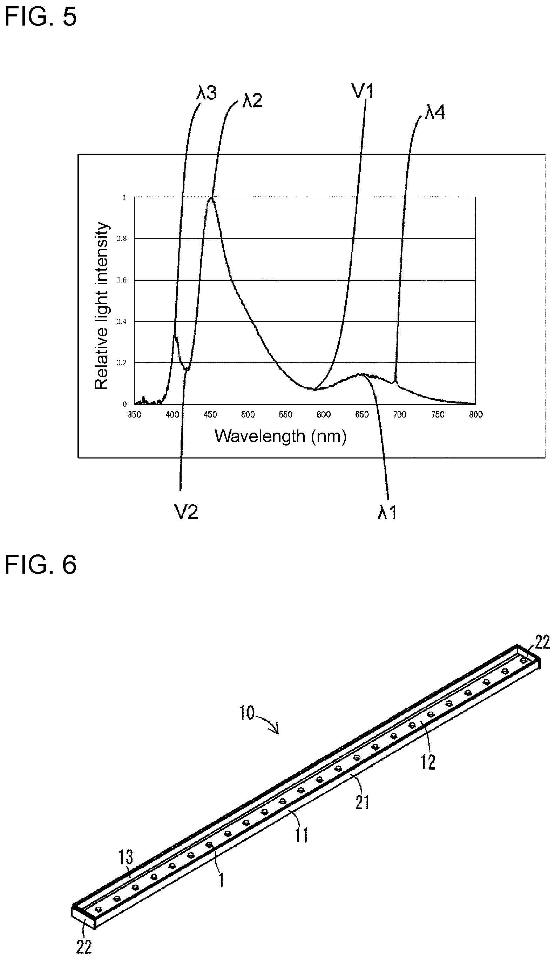

FIGs. 4 and 5 are graphs each showing an example emission spectrum of light from the light-emitting device 1. In the graphs in FIGs. 4 and 5, the horizontal axis indicates the wavelength of light emitted from the light-emitting device 1, and the vertical axis indicates the relative light intensity of the light. The relative light intensity is, relative to the light intensity at a selected peak wavelength being 1, the ratio of the light intensity to the light intensity at the selected peak wavelength. In the graphs in FIGs. 4 and 5, the vertical axis indicates the relative light intensity of light emitted from the light-emitting device 1 when the light intensity at a second peak wavelength λ2 in a wavelength range of 430 to 480 nm (described below) is 1.

The light emitter 3 emits light having a third peak wavelength λ3 in a wavelength region of 380 to 430 nm. The wavelength region of 380 to 430 nm is included in the visible light region. The wavelength region of 380 to 430 nm is also referred to as a violet light region.

The frame 4 may be formed from, for example, a ceramic material such as aluminum oxide, titanium oxide, zirconium oxide, or yttrium oxide. The frame 4 may be formed from a porous material. The frame 4 may be formed from a resin material containing a mixture of powders of, for example, metal oxide such as aluminum oxide, titanium oxide, zirconium oxide, or yttrium oxide. The frame 4 may be formed from a material selected from various materials other than these materials.

The frame 4 is bonded to the main surface of the component-mount board 2 with, for example, a resin, a brazing material, or solder. The frame 4 on the main surface of the component-mount board 2 is spaced from the multiple light emitters 3 on the main surface of the component-mount board 2 to surround the light emitters 3. The frame 4 has an inner sloping wall that flares outward away from the main surface of the component-mount board 2. The inner wall surface functions as a reflective surface to reflect light emitted from the multiple light emitters 3. The inner wall surface may include, for example, a metal layer formed from a metal material such as tungsten, molybdenum, or manganese, and a plating layer that covers the metal layer and is formed from a metal material such as nickel or gold. The plating layer reflects light emitted from the multiple light emitters 3.

The frame 4 may have the inner wall that is circular in a plan view. With the inner wall being circular, the frame 4 can reflect light emitted from the multiple light emitters 3 uniformly outward. The frame 4 may have the inner wall sloping at an angle of, for example, 55 to 70° inclusive with the main surface of the component-mount board 2.

The sealant 5 fills the inner space defined by the component-mount board 2 and the frame 4 except an upper area of the inner space defined by the frame 4. The sealant 5 encapsulates the multiple light emitters 3 while allowing transmission of light emitted from the multiple light emitters 3. The sealant 5 may be formed from, for example, a light-transmissive material. The sealant 5 may be formed from, for example, an insulating resin material transmissive to light, such as a silicone resin, an acrylic resin, or an epoxy resin, or a glass material transmissive to light. The sealant 5 may have a refractive index of, for example, 1.4 to 1.6 inclusive.

The wavelength converter 6 includes multiple phosphors 60. The phosphors 60 can convert light with a peak wavelength (third peak wavelength λ3) in the wavelength region of 380 to 430 nm into light with a peak wavelength (first peak wavelength λ1) in a wavelength region of 630 to 680 nm and also into light with a peak wavelength (second peak wavelength λ2) in the wavelength region of 430 to 480 nm. The wavelength converter 6 is at a position appropriate to convert light emitted from the light emitters 3 into light with the peak wavelengths in the wavelength regions of 630 to 680 nm and 430 to 480 nm. The wavelength region of 430 to 680 nm is included in the visible light region. In the examples shown in FIGs. 1 to 3, the wavelength converter 6 is above the sealant 5 that fills the area defined by the component-mount board 2 and the frame 4. In the illustrated example, the upper surface of the wavelength converter 6 is flush with the upper surface of the frame 4. The position of the wavelength converter 6 is not limited to this example. For example, the wavelength converter 6 may be on the upper surface of the frame 4 and cover the area defined by the component-mount board 2 and the frame 4.

The wavelength converter 6 further includes a light-transmissive member. The wavelength converter 6 includes the phosphors 60 contained in the light-transmissive member. The amounts of phosphors 60 contained in the light-transmissive member are determined as appropriate. The phosphors 60 are dispersed substantially uniformly in the light-transmissive member. Light emitted from each light emitter 3 enters the wavelength converter 6 through the sealant 5.

The light-transmissive member may be formed from, for example, an insulating resin material that is transmissive to light, such as a fluororesin, a silicone resin, an acrylic resin, or an epoxy resin, or a glass material that is transmissive to light.

The phosphors 60 include a first phosphor having a peak wavelength in the wavelength region of 600 to 680 nm. Such phosphors may include a red phosphor. Examples of the red phosphor include Y₂O₂S:Eu, Y₂O₃:Eu, SrCaClAlSiN₃:Eu²⁺, CaAlSiN₃:Eu, and CaAlSi(ON)₃:Eu. The red phosphor can convert light entering the wavelength converter 6 into light with a peak wavelength in the wavelength region of 630 to 680 nm and emits the resultant light. In addition to the red phosphor described above, the wavelength converter 6 may also include, for example, a phosphor with a color in the near-infrared region having a peak wavelength in a wavelength region of 680 to 800 nm. Examples of the phosphor with a color in the near-infrared region include 3Ga₃O₁₂:Cr.

The phosphors 60 also include a second phosphor 62 that can convert incoming light into light identifiable with a spectrum having a peak wavelength in the wavelength region of 430 to 480 nm, or specifically, into blue light. Examples of the second phosphor 62 include BaMgAl₁₀O₁₇:Eu, (Sr, Ca, Ba)₁₀(PO₄)6Cl₂:Eu, and (Sr, Ba)₁₀(PO₄)₆Cl₂:Eu. The second phosphor 62 may convert incoming light into light identifiable with a spectrum having a peak wavelength in a wavelength region of 450 to 550 nm, or specifically, into blue green light. Examples of the second phosphor 62 include (Sr, Ba, Ca)₃(PO₄)₃Cl:Eu and Sr₄Al₁₄O₂₅:Eu.

The wavelength converter 6 may further include a phosphor that can convert incoming light into light identifiable with a spectrum with a peak wavelength in a wavelength region of 500 to 600 nm, or specifically, into green light. Examples of such a phosphor include SrSi₂(O, Cl)₂N₂:Eu, (Sr, Ba, Mg)₂SiO₄:Eu²⁺, ZnS:Cu, Al, and Zn₂SiO₄:Mn.

The phosphors 60 combining two or more of the phosphors described above can have the first peak wavelength λ1 in the wavelength region of 630 to 680 nm and the second peak wavelength λ2 in the wavelength region of 430 to 480 nm.

A peak wavelength herein (described above and below) refers to a maximum value of the spectrum, or specifically, the wavelength at a crest of the spectrum that changes from a trough to a crest and then back to a trough. However, the spectrum of any light to be emitted with various colors using phosphors may also have minor crests and troughs. A peak wavelength herein is not identified by such minor crests and troughs. More specifically, for example, a maximum value between a trough to a trough with a trough-to-trough width of 10 nm or less may not be used as a peak wavelength.

### Emission Spectrum of Light-emitting Device

The light-emitting device 1 according to an embodiment of the present disclosure emits light (first light) having the third peak wavelength λ3 in the wavelength region of 380 to 430 nm, the second peak wavelength λ2 in the wavelength region of 430 to 480 nm, and the first peak wavelength λ1 in the wavelength region of 630 to 680 nm. To reproduce sunlight in the sea, the light intensity of light at the second peak wavelength λ2 is to be at the maximum in a wavelength range of 350 to 800 nm. The first light may have, relative to its light intensity at the second peak wavelength λ2 being 1, a relative light intensity of 0.25 to 0.45 at the third peak wavelength λ3 and a relative light intensity of 0.05 to 0.35 at the first peak wavelength λ1. In the sea, the light intensity of sunlight in the wavelength region of 630 to 680 nm decreases as the depth of water increases. For example, the relative light intensity of sunlight in the wavelength region of 630 to 680 nm is almost zero at and below a certain depth in the sea. To reproduce sunlight in the sea, the relative light intensity of light is thus to be set to almost zero in the wavelength region of 630 to 680 nm. However, adding light with the relative light intensity of 0.05 or greater in the wavelength region of 630 to 680 nm at the first peak wavelength λ1, or in other words, adding red light, allows aquatic organisms to appear more vivid. Further, light with the relative light intensity of 0.35 or less in the wavelength region of 630 to 680 nm including the first peak wavelength λ1 is less likely to reduce reproducibility of the spectrum of sunlight in the sea. The relative light intensity of light in the wavelength region of 630 to 680 nm can be adjusted by changing the type of the red phosphor and its amount. The relative light intensity of light may be 0.05 to 0.35 throughout the wavelength region of 630 to 680 nm.

The third peak wavelength λ3 is the peak wavelength of excitation light (second light) of each light emitter 3. When the relative light intensity of the excitation light (second light) is in the range of 0.25 and 0.45, the colors of the light to be emitted are less likely to be affected by any direct violet light leaking outside. In this case, the emission intensity of light with any intended color can also be maintained sufficiently.

The first light may have an emission spectrum with a minimum value of the light intensity in a wavelength region from 480 nm to the first peak wavelength λ1. The light having the first minimum value V1 of the light intensity in the wavelength region from 480 nm to the first peak wavelength λ1 can reproduce the color at around the second peak wavelength λ2 and the first peak wavelength λ1. The emission spectrum in the sea is more likely to be reproduced. For light with the relative light intensity of 0.1 or less in the wavelength range of 380 to 430 nm, the emitted light is less likely to affect the colors of the light, thus increasing the likelihood of reproducing intended light.

The first light may have the ratio of the second spectral distribution of the emission spectrum in the wavelength region of 430 to 480 nm to the emission spectral distribution of the emission spectrum in the wavelength region of 350 to 800 nm being 40 to 50%. Of the spectral distributions of the emission spectrum, the emission spectral distribution refers to the spectral distribution of the emission spectrum in the wavelength region of 350 to 800 nm, the first spectral distribution refers to the spectral distribution of the emission spectrum in the wavelength region of 630 to 680 nm, the second spectral distribution refers to the emission spectrum in the wavelength region of 430 to 480 nm, the third spectral distribution refers to the spectral distribution of the emission spectrum in the wavelength region of 380 to 430 nm, and the fourth spectral distribution refers to the spectral distribution of the emission spectrum in a wavelength region of 430 to 550 nm. The spectral distribution herein is equivalent to the area of the spectrum. In other words, the spectral distribution herein is the integral value (area ratio) of a specific wavelength region.

For the spectrum of sunlight in the sea, the ratio of the second spectral distribution in the wavelength region of 430 to 480 nm increases as the depth of water increases. For corals and other aquatic organisms that live at around 10 to 50 m underwater, for example, light with the light intensity too low in the wavelength region of 430 to 480 nm can inhibit their growth, and light with the light intensity too high in the wavelength region of 430 to 480 nm is less likely to reproduce the spectrum of sunlight at 10 to 50 m underwater. Thus, the ratio of the second spectral distribution of the emission spectrum in the wavelength region of 430 to 480 nm may be 40 to 50% to promote the growth of aquatic organisms that live at 10 to 50 m underwater, and also is more likely to reproduce the spectrum of sunlight in the sea and allow objects to appear vivid for viewing aquatic organisms. The ratio of the first spectral distribution of the emission spectrum in the wavelength region of 630 to 680 nm to the emission spectral distribution of the emission spectrum in the wavelength region of 350 to 800 nm may be 3 to 10%. At this ratio being 3% or greater, an additional small amount of red light can allow objects to appear vivid for viewing aquatic organisms. At this ratio being 10% or less, the emission spectrum is more likely to reproduce the spectrum of sunlight in the sea.

Light emitted from the light-emitting device 1 may further have a fourth peak wavelength λ4 in a wavelength region of 680 to 710 nm, and the relative light intensity of the light at the fourth peak wavelength λ4 may be 0.05 to 0.35. The fourth peak wavelength λ4 is continuous with the first peak wavelength λ1 and may have a maximum value at an additional crest in a portion of the first peak wavelength λ1. At the relative light intensity being 0.05 to 0.35, an additional small amount of red light can allow aquatic organisms to appear vivid, and the emission spectrum to be suitable for viewing aquatic organisms while maintaining the reproduction of the spectrum of sunlight in the sea. The half-width at the fourth peak wavelength λ4 may be one-third or less of the half-width at the first peak wavelength λ1. Light with the half-width being one-third or less of the half-width of the first peak wavelength λ1 is less likely to reduce reproducibility of the spectrum of sunlight in the sea. The relative light intensity at the fourth peak wavelength λ4 may be in the range of 0.7 to 1 inclusive relative to the relative light intensity at the first peak wavelength λ1, or may be less than the relative light intensity at the third peak wavelength λ3.

As shown in FIGs. 4 and 5, the ratio of the third spectral distribution of the emission spectrum in the wavelength range of 380 to 430 nm to the emission spectral distribution of the emission spectrum in the wavelength region of 350 to 800 nm is 8 to 10%. When the ratio of light close to the excitation light is within this numerical range, the colors of the light to be emitted are less likely to be affected by any direct violet light leaking outside. The emission intensity of light with intended colors can also be maintained sufficiently.

The relative light intensity at the first minimum value V1 may be 0.05 to 0.1 when the light intensity at the second peak wavelength λ2 is 1. The relative light intensity at the first minimum value V1 being in this numerical range allows light to have a balance of colors similar to the balance between the blue and red elements of sunlight in the sea, and also allows objects to appear more vivid.

The spectrum of light also has a second minimum value V2 between the second peak wavelength λ2 and the third peak wavelength λ3. The relative light intensity at the second minimum value V2 may be 0.1 to 0.2 when the light intensity at the second peak wavelength λ2 is 1. The relative light intensity at the second minimum value V2 being in this numerical range allows light to have a balance of colors similar to the balance between the violet and blue elements of sunlight in the sea, and also the colors of emitted light are less likely to be affected by any direct violet light emitted outside.

The relative light intensity of the light at the second minimum value V2 may be greater than the relative light intensity of the light at the first minimum value V1. The light-emitting device 1 can emit light with a balance between the excitation light element, the blue light element, and the red light element similar to the balance between these elements in sunlight in the sea.

The shape of the emission spectrum in the wavelength range of 430 to 550 nm may be asymmetric with the second peak wavelength λ2 at the center. The shape of an emission spectrum is the waveform of the spectrum. In this case, the emission spectrum may be wider at longer wavelengths than at the second peak wavelength λ2. For example, the relative light intensity of the light at the wavelength that is 30 nm away from the second peak wavelength λ2 toward the longer wavelength end is greater than the relative light intensity of the light at the wavelength that is 30 nm away from the second peak wavelength λ2 toward the shorter wavelength end. In other words, in a wavelength range of 430 to 490 nm, the spectral distribution is larger toward longer wavelengths than at shorter wavelengths with the second peak wavelength λ2 at the center. This results from light excited by the phosphors 60 spreading toward longer wavelengths than the wavelength of the excitation light. The light to be reproduced can have intended emission intensity without its excitation light element being too large. The spread of the emission spectrum of light toward longer wavelengths and the relative light intensity of the light can be adjusted by adjusting the types and amounts (e.g., the volume ratio) of the phosphors 60 dispersed in the wavelength converter 6.

The ratio of the fourth spectral distribution of the emission spectrum in the wavelength region of 430 to 550 nm to the emission spectral distribution of the emission spectrum in the wavelength region of 350 to 800 nm may be 65 to 80%. The light with the large ratio of the blue and green wavelength regions can be similar to sunlight that has a smaller ratio of red element in the sea.

### Structure of Illumination Apparatus

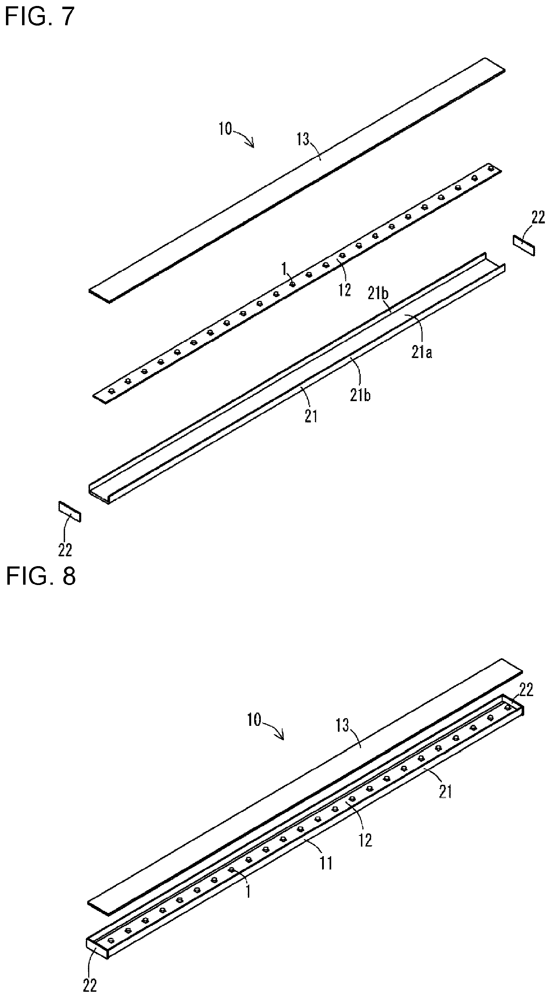

FIG. 6 is a perspective view of the illumination apparatus 10 including the light-emitting devices 1 according to the present embodiment. FIG. 7 is an exploded perspective view of the illumination apparatus 10 including the light-emitting devices 1 according to the present embodiment. FIG. 7 is a perspective view of the illumination apparatus 10 shown in FIG. 6 with a light-transmissive substrate removed from a housing. The illumination apparatus 10 includes multiple light-emitting devices 1 including light emitters 3. The illumination apparatus 10 combines light emitted from each of the multiple light-emitting devices 1 into composite light. The illumination apparatus 10 emits light with the third peak wavelength λ3 in the wavelength region of 380 to 430 nm, the second peak wavelength λ2 in the wavelength region of 430 to 480 nm, and the first peak wavelength λ1 in the wavelength region of 630 to 680 nm.

The illumination apparatus 10 includes an elongated housing 11, the light-emitting devices 1, an elongated wiring board 12, and an elongated light-transmissive substrate 13. The housing 11 is open upward. The housing 11 accommodates the light-emitting devices 1 arranged in line in the longitudinal direction. The wiring board 12 receives the light-emitting devices 1. The light-transmissive substrate 13 is supported by the housing 11 and closes the opening of the housing 11.

Although the first light in one light-emitting device 1 has the spectrum described in the above embodiment, composite light obtained by combining light from each of the multiple light-emitting devices 1, or specifically light emitted from the illumination apparatus 10, may have the spectrum described above. In this case, the light emitters 3 can also emit light with the third peak wavelength λ3 in the wavelength region of 380 to 430 nm. The light can be reproduced by changing the types of phosphors as appropriate.

The housing 11 supports the light-transmissive substrate 13 and dissipates heat generated by the light-emitting devices 1 outside. The housing 11 is formed from, for example, metal such as aluminum, copper, or stainless steel, plastics, or a resin. The housing 11 has a bottom 21a extending in the longitudinal direction, a pair of supports 21b extending upright from the two ends of the bottom 21a in the width direction and extending in the longitudinal direction, an elongated body 21 that is open upward and open at two ends in the longitudinal direction, and two lids 22 for closing the open ends in the longitudinal direction of the body 21. The supports 21b each have, on the upper inner surface of the housing 11, holders including recesses facing each other to support the light-transmissive substrate 13 in the longitudinal direction. The housing 11 has a length of, for example, 100 to 2000 mm inclusive in the longitudinal direction.

The wiring board 12 is fixed on the bottom inside the housing 11. The wiring board 12 may be, for example, a printed board such as a rigid printed board, a flexible printed board, or a rigid flexible printed board. The wiring pattern on the wiring board 12 and the wiring pattern on the component-mount board 2 included in each light-emitting device 1 are electrically connected to each other with solder or a conductive adhesive. A signal from the wiring board 12 is transmitted to the light emitter 3 through the component-mount board 2. The light emitter 3 then emits light. The wiring board 12 may be powered by an external power supply through wiring.

The light-transmissive substrate 13 is formed from a material that is transmissive to light emitted from each light-emitting device 1. The light-transmissive substrate 13 may be formed from, for example, a light-transmissive material such as an acrylic resin or glass. The light-transmissive substrate 13 is a rectangular plate and has a length of, for example, 98 to 1998 mm inclusive in the longitudinal direction. The light-transmissive substrate 13 is inserted through either of the two open ends of the body 21 in the longitudinal direction along the above recesses on the supports 21b, is then slid in the longitudinal direction, and is thus supported by the pair of supports 21b at positions spaced from the multiple light-emitting devices 1. The open ends of the body 21 in the longitudinal direction are then closed with the lids 22. This completes the illumination apparatus 10.

The illumination apparatus 10 described above is a line emission apparatus including the multiple light-emitting devices 1 arranged linearly. In some embodiments, the illumination apparatus may be a plane emission apparatus including multiple light-emitting devices 1 arranged in a matrix or in a staggered pattern.

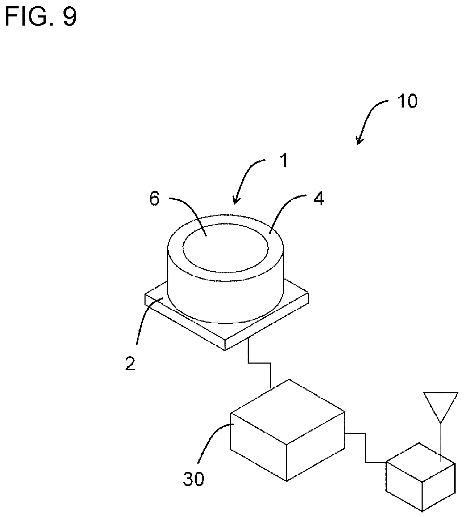

As shown in FIG. 9, the illumination apparatus 10 may include a controller 30 that adjusts the light intensity (dimming rate) of the light-emitting device 1. The controller 30 may increase the light intensity to allow fish to appear more vivid and clearer, and may decrease the light intensity in the spectrum to reproduce sunlight in the sea at night in the wavelength region of 430 to 480 nm as the depth of water increases. To reduce physical impacts on fish, the controller 30 may control the light intensity to change slowly over time to avoid a great change in the light intensity at a time. The controller 30 can adjust the intensity of light emitted from the light-emitting device 1 by controlling the current value flowing through the light-emitting device 1. The controller 30 can also adjust light emitted from the light-emitting device 1 to be shimmering by varying the dimming rate over time or by varying the dimming rate randomly. The controller 30 may be mounted on the wiring board 12 together with other components, or the illumination apparatus 10 may include a receiver that receives commands externally generated and provided through wireless communication to the wiring board 12 or other components that control the current.

The illumination apparatus 10 including the controller 30 that can control dimming can reproduce light with different intensity levels (light or dark) although the light has the same color temperature.

### Example Use of Illumination Apparatus

The illumination apparatus 10 according to one or more embodiments of the present disclosure includes the light-emitting devices 1 with the above structure. The illumination apparatus 10 can thus reproduce light similar to sunlight underwater. For example, the illumination apparatus 10 may be placed in a watertank to allow viewers to watch fish or other aquatic organisms in an environment similar to an underwater environment. The colors of such aquatic organisms appear vivid. For a smaller watertank, the illumination apparatus 10 may be attached to the top of the tank to illuminate the tank from above. The illumination apparatus 10 may also be attached at any height adjusted as appropriate for fish positions.

The illumination apparatus 10 may be used not only indoors, such as in a building or a house, but may also be used outdoors.

The drawings describing the structure according to the present invention are schematic. The drawings are not drawn to scale relative to the actual size of each component.

Although the above embodiments are described as typical examples, various modifications and substitutions to the embodiments are apparent to those skilled in the art without departing from the scope of the present invention as defined by the claims. Thus, the structure according to one or more embodiments of the present invention should not be construed to be restrictive, but may be variously modified or altered within the scope of the present invention as defined by the claims. The present invention is not limited to the examples described in the above embodiments and may include various modifications of, for example, numerical values, within the scope of the present invention as defined by the claims.

### Reference Signs List

- 1: light-emitting device
- 2: component-mount board
- 3: light emitter
- 4: frame
- 5: sealant
- 6: wavelength converter
- 60: phosphor
- λ1: first peak wavelength
- λ2: second peak wavelength
- λ3: third peak wavelength
- λ4: fourth peak wavelength
- V1: first minimum value
- V2: second minimum value
- 10: illumination apparatus
- 11: housing
- 12: wiring board
- 13: light-transmissive substrate
- 21: body
- 21a: bottom
- 21b: support
- 22: lid
- 30: controller

## Claims

1. A light-emitting device (1) comprising:
a light emitter (3) configured to emit light having a third peak wavelength (λ3) in a wavelength region of 380 to 430 nm, and
a wavelength converter (6) configured to convert the light emitted from the light emitter (3) into light with a first peak wavelength (λ1) in a wavelength region of 630 to 680 nm as well as with a second peak wavelength (λ2) in a wavelength region of 430 to 480 nm,
wherein the wavelength converter (6) includes multiple phosphors (60) contained in a light-transmissive member, the multiple phosphors (60) including a first phosphor (60) configured to convert the light emitted from the light emitter (3) into light with the first peak wavelength (λ1) and a second phosphor (62) configured to convert the light emitted from the light emitter (3) into light with the second peak wavelength (λ2),
wherein the light-emitting device (1) is configured to emit light having the first peak wavelength (λ1), the second peak wavelength (λ2), and the third peak wavelength (λ3), and having, relative to a light intensity of the light at the second peak wavelength (λ2) being 1, a relative light intensity of 0.05 to 0.35 at the first peak wavelength (λ1), a relative light intensity of 0.25 to 0.45 at the third peak wavelength (λ3), and a first minimum value (V1) of the light intensity in a wavelength region from 480 nm to the first peak wavelength (λ1).

2. The light-emitting device (1) according to claim 1, wherein
the light emitted from the light-emitting device (1) has an asymmetric emission spectrum with the second peak wavelength (λ2) at a center in a wavelength range of 430 to 550 nm and includes a relative light intensity at a wavelength that is 30 nm away from the second peak wavelength (λ2) toward the longer wavelength end that is greater than a relative light intensity at a wavelength that is 30 nm away from the second peak wavelength (λ2) toward the shorter wavelength end.

3. The light-emitting device (1) according to claim 1 or claim 2, wherein
the light emitted from the light-emitting device (1) has a ratio of a first spectral distribution of a first emission spectrum in the wavelength region of 630 to 680 nm to an emission spectral distribution of an emission spectrum in a wavelength region of 350 to 800 nm being 3 to 10%.

4. The light-emitting device (1) according to any one of claims 1 to 3, wherein
the light emitted from the light-emitting device (1) has a ratio of a second spectral distribution of a second emission spectrum in the wavelength region of 430 to 480 nm to an emission spectral distribution of an emission spectrum in a wavelength region of 350 to 800 nm being 40 to 50%.

5. The light-emitting device (1) according to any one of claims 1 to 4, wherein
the light emitted from the light-emitting device (1) further has a fourth peak wavelength (λ4) in a wavelength region of 680 to 710 nm, and
the light emitted from the light-emitting device (1) has, relative to a light intensity of the light emitted from the light-emitting device (1) at the second peak wavelength (λ2) being 1, a relative light intensity of 0.05 to 0.35 at the fourth peak wavelength (λ4).

6. The light-emitting device (1) according to claim 5, wherein
a half-width at the fourth peak wavelength (λ4) is one-third or less of a half-width at the first peak wavelength (λ1).

7. The light-emitting device (1) according to claim 5 or claim 6, wherein
a relative light intensity at the fourth peak wavelength (λ4) is 0.7 or greater relative to a relative light intensity at the first peak wavelength (λ1).

8. The light-emitting device (1) according to any one of claims 1 to 7, wherein
the light emitted from the light-emitting device (1) has a ratio of a third spectral distribution of an emission spectrum in the wavelength region of 380 to 430 nm to an emission spectral distribution of an emission spectrum in a wavelength region of 350 to 800 nm being 8 to 10%.

9. The light-emitting device (1) according to any one of claims 1 to 8, wherein
the light emitted from the light-emitting device (1) has, relative to a light intensity of the light emitted from the light-emitting device (1) at the second peak wavelength (λ2) being 1, a relative light intensity of 0.05 to 0.1 at the first minimum value (V1).

10. The light-emitting device (1) according to any one of claims 1 to 9, wherein
the light emitted from the light-emitting device (1) has a second minimum value (V2) of a light intensity between the second peak wavelength (λ2) and the third peak wavelength (λ3), and
the light emitted from the light-emitting device (1) has, relative to a light intensity of the light emitted from the light-emitting device (1) at the second peak wavelength (λ2) being 1, a relative light intensity of 0.1 to 0.2 at the second minimum value (V2).

11. The light-emitting device (1) according to claim 10, wherein
the relative light intensity of the light emitted from the light-emitting device (1) at the second minimum value (V2) is greater than a relative light intensity at the first minimum value (V1).

12. The light-emitting device (1) according to any one of claims 1 to 11, wherein
the light emitted from the light-emitting device (1) has a maximum light intensity in a wavelength range of 350 to 800 nm at the second peak wavelength (λ2).

13. The light-emitting device (1) according to claim 1, wherein
the light emitted from the light-emitting device (1) has an emission spectrum asymmetric with the second peak wavelength (λ2) at a center in a wavelength range of 430 to 550 nm.

14. The light-emitting device (1) according to any one of claims 1 to 13, wherein
the light emitted from the light-emitting device (1) has a ratio of a fourth spectral distribution of an emission spectrum in a wavelength region of 430 to 550 nm to an emission spectral distribution of an emission spectrum in a wavelength region of 350 to 800 nm being 65 to 80%.

15. An illumination apparatus (10), comprising:
one or more light-emitting devices (1) according to any one of claims 1 to 14.

16. The illumination apparatus (10) according to claim 15, further comprising:
a controller (30) configured to adjust light intensities of the one or more light-emitting devices (1).

## Patentansprüche

1. Lichtemittierende Vorrichtung (1), aufweisend:
einen Lichtemitter (3), der konfiguriert ist, um Licht mit einer dritten Spitzenwellenlänge (λ3) in einem Wellenlängenbereich von 380 bis 430 nm zu emittieren, und
einen Wellenlängenwandler (6), der konfiguriert ist, um das vom Lichtemitter (3) emittierte Licht in Licht mit einer ersten Spitzenwellenlänge (λ1) in einem Wellenlängenbereich von 630 bis 680 nm sowie mit einer zweiten Spitzenwellenlänge (λ2) in einem Wellenlängenbereich von 430 bis 480 nm umzuwandeln,
wobei der Wellenlängenwandler (6) mehrere in einem lichtdurchlässigen Element enthaltene Leuchtstoffe (60) aufweist, wobei die mehreren Leuchtstoffe (60) aufweisen: einen ersten Leuchtstoff (60), der konfiguriert ist, um das vom Lichtemitter (3) emittierte Licht in Licht mit der ersten Spitzenwellenlänge (λ1) umzuwandeln, und einen zweiten Leuchtstoff (62), der konfiguriert ist, um das vom Lichtemitter (3) emittierte Licht in Licht mit der zweiten Spitzenwellenlänge (A2) umzuwandeln,
wobei die lichtemittierende Vorrichtung (1) konfiguriert ist, um Licht zu emittieren mit der ersten Spitzenwellenlänge (λ1), der zweiten Spitzenwellenlänge (λ2) und der dritten Spitzenwellenlänge (A3), und mit, relativ zu einer Lichtintensität des Lichts bei der zweiten Spitzenwellenlänge (A2) von 1, einer relativen Lichtintensität von 0,05 bis 0,35 bei der ersten Spitzenwellenlänge (λ1), einer relativen Lichtintensität von 0,25 bis 0,45 bei der dritten Spitzenwellenlänge (λ3) und einem ersten Minimalwert (V1) der Lichtintensität in einem Wellenlängenbereich von 480 nm bis zur ersten Spitzenwellenlänge (λ1).

2. Lichtemittierende Vorrichtung (1) gemäß Anspruch 1, wobei
das von der lichtemittierenden Vorrichtung (1) emittierte Licht ein asymmetrisches Emissionsspektrum mit der zweiten Spitzenwellenlänge (λ2) in einer Mitte in einem Wellenlängenbereich von 430 bis 550 nm hat und eine relative Lichtintensität bei einer Wellenlänge aufweist, die 30 nm von der zweiten Spitzenwellenlänge (λ2) in Richtung zu dem längeren Wellenlängenende entfernt ist und größer ist als eine relative Lichtintensität bei einer Wellenlänge, die 30 nm von der zweiten Spitzenwellenlänge (λ2) in Richtung zu dem kürzeren Wellenlängenende entfernt ist.

3. Lichtemittierende Vorrichtung (1) gemäß Anspruch 1 oder Anspruch 2, wobei
das von der lichtemittierenden Vorrichtung (1) emittierte Licht ein Verhältnis einer ersten Spektralverteilung eines ersten Emissionsspektrums im Wellenlängenbereich von 630 bis 680 nm zu einer Emissionsspektralverteilung eines Emissionsspektrums in einem Wellenlängenbereich von 350 bis 800 nm von 3 bis 10 % hat.

4. Lichtemittierende Vorrichtung (1) gemäß irgendeinem der Ansprüche 1 bis 3, wobei
das von der lichtemittierenden Vorrichtung (1) emittierte Licht ein Verhältnis einer zweiten Spektralverteilung eines zweiten Emissionsspektrums im Wellenlängenbereich von 430 bis 480 nm zu einer Emissionsspektralverteilung eines Emissionsspektrums in einem Wellenlängenbereich von 350 bis 800 nm von 40 bis 50 % hat.

5. Lichtemittierende Vorrichtung (1) gemäß irgendeinem der Ansprüche 1 bis 4, wobei
das von der lichtemittierenden Vorrichtung (1) emittierte Licht ferner eine vierte Spitzenwellenlänge (λ4) in einem Wellenlängenbereich von 680 bis 710 nm hat, und
das von der lichtemittierenden Vorrichtung (1) emittierte Licht relativ zu einer Lichtintensität des von der lichtemittierenden Vorrichtung (1) bei der zweiten Spitzenwellenlänge (λ2) emittierten Lichts von 1 eine relative Lichtintensität von 0,05 bis 0,35 bei der vierten Spitzenwellenlänge (λ4) hat.

6. Lichtemittierende Vorrichtung (1) gemäß Anspruch 5, wobei
eine Halbwertsbreite bei der vierten Spitzenwellenlänge (λ4) ein Drittel oder weniger einer Halbwertsbreite bei der ersten Spitzenwellenlänge (λ1) ist.

7. Lichtemittierende Vorrichtung (1) gemäß Anspruch 5 oder Anspruch 6, wobei
eine relative Lichtintensität bei der vierten Spitzenwellenlänge (A4) 0,7 oder größer ist, bezogen auf eine relative Lichtintensität bei der ersten Spitzenwellenlänge (A1).

8. Lichtemittierende Vorrichtung (1) gemäß irgendeinem der Ansprüche 1 bis 7, wobei
das von der lichtemittierenden Vorrichtung (1) emittierte Licht ein Verhältnis einer dritten Spektralverteilung eines Emissionsspektrums im Wellenlängenbereich von 380 bis 430 nm zu einer Emissionsspektralverteilung eines Emissionsspektrums in einem Wellenlängenbereich von 350 bis 800 nm von 8 bis 10 % hat.

9. Lichtemittierende Vorrichtung (1) gemäß irgendeinem der Ansprüche 1 bis 8, wobei
das von der lichtemittierenden Vorrichtung (1) emittierte Licht, relativ zu einer Lichtintensität des von der lichtemittierenden Vorrichtung (1) bei der zweiten Spitzenwellenlänge (λ2) emittierten Lichts von 1, eine relative Lichtintensität von 0,05 bis 0,1 beim ersten Minimalwert (V1) hat.

10. Lichtemittierende Vorrichtung (1) gemäß irgendeinem der Ansprüche 1 bis 9, wobei
das von der lichtemittierenden Vorrichtung (1) emittierte Licht einen zweiten Minimalwert (V2) einer Lichtintensität zwischen der zweiten Spitzenwellenlänge (λ2) und der dritten Spitzenwellenlänge (λ3) hat, und
das von der lichtemittierenden Vorrichtung (1) emittierte Licht, relativ zu einer Lichtintensität des von der lichtemittierenden Vorrichtung (1) bei der zweiten Spitzenwellenlänge (A2) emittierten Lichts von 1, eine relative Lichtintensität von 0,1 bis 0,2 beim zweiten Minimalwert (V2) hat.

11. Lichtemittierende Vorrichtung (1) gemäß Anspruch 10, wobei
die relative Lichtintensität des von der lichtemittierenden Vorrichtung (1) emittierten Lichts beim zweiten Minimalwert (V2) größer als eine relative Lichtintensität beim ersten Minimalwert (V1) ist.

12. Lichtemittierende Vorrichtung (1) gemäß irgendeinem der Ansprüche 1 bis 11, wobei
das von der lichtemittierenden Vorrichtung (1) emittierte Licht eine maximale Lichtintensität in einem Wellenlängenbereich von 350 bis 800 nm bei der zweiten Spitzenwellenlänge (λ2) hat.

13. Lichtemittierende Vorrichtung (1) gemäß Anspruch 1, wobei
das von der lichtemittierenden Vorrichtung (1) emittierte Licht ein Emissionsspektrum hat, das mit der zweiten Spitzenwellenlänge (λ2) in einer Mitte in einem Wellenlängenbereich von 430 bis 550 nm asymmetrisch ist.

14. Lichtemittierende Vorrichtung (1) gemäß irgendeinem der Ansprüche 1 bis 13, wobei
das von der lichtemittierenden Vorrichtung (1) emittierte Licht ein Verhältnis einer vierten Spektralverteilung eines Emissionsspektrums in einem Wellenlängenbereich von 430 bis 550 nm zu einer Emissionsspektralverteilung eines Emissionsspektrums in einem Wellenlängenbereich von 350 bis 800 nm von 65 bis 80 % hat.

15. Beleuchtungsvorrichtung (10), aufweisend:
eine oder mehrere lichtemittierende Vorrichtungen (1) gemäß irgendeinem der Ansprüche 1 bis 14.

16. Beleuchtungsvorrichtung (10) gemäß Anspruch 15, ferner aufweisend:
eine Steuereinrichtung (30), die konfiguriert ist, um Lichtintensitäten der einen oder mehreren lichtemittierenden Vorrichtungen (1) einzustellen.

## Revendications

1. Dispositif électroluminescent (1), comprenant :
un émetteur de lumière (3) configuré pour émettre une lumière ayant une troisième longueur d'onde de pic (λ3) dans une région de longueurs d'onde de 380 à 430 nm, et
un convertisseur de longueur d'onde (6) configuré pour convertir la lumière émise depuis l'émetteur de lumière (3) en une lumière ayant une première longueur d'onde de pic (λ1) dans une région de longueurs d'onde de 630 à 680 nm ainsi qu'une deuxième longueur d'onde de pic (λ2) dans une région de longueurs d'onde de 430 à 480 nm,
dans lequel le convertisseur de longueur d'onde (6) comprend plusieurs phosphores (60) contenus dans un élément transmettant la lumière, les plusieurs phosphores (60) comprenant un premier phosphore (60) configuré pour convertir la lumière émise depuis l'émetteur de lumière (3) en lumière ayant la première longueur d'onde de pic (λ1) et un deuxième phosphore (62) configuré pour convertir la lumière émise depuis l'émetteur de lumière (3) en lumière ayant la deuxième longueur d'onde de pic (λ2),
dans lequel le dispositif électroluminescent (1) est configuré pour émettre une lumière ayant la première longueur d'onde de pic (λ1), la deuxième longueur d'onde de pic (λ2) et la troisième longueur d'onde de pic (λ3), et ayant, par rapport à une intensité de lumière de la lumière à la deuxième longueur d'onde de pic (λ2) étant 1, une intensité de lumière relative de 0,05 à 0,35 à la première longueur d'onde de pic (λ1), une intensité de lumière relative de 0,25 à 0,45 à la troisième longueur d'onde de pic (λ3), et une première valeur minimale (V1) de l'intensité de lumière dans une région de longueurs d'onde de 480 nm à la première longueur d'onde de pic (λ1).

2. Dispositif électroluminescent (1) selon la revendication 1, dans lequel
la lumière émise depuis le dispositif électroluminescent (1) présente un spectre d'émission asymétrique avec la deuxième longueur d'onde de pic (λ2) à un centre dans une plage de longueurs d'onde de 430 à 550 nm et comprend une intensité de lumière relative à une longueur d'onde qui est à 30 nm de la deuxième longueur d'onde de pic (λ2) vers l'extrémité de longueur d'onde plus longue qui est supérieure à une intensité de lumière relative à une longueur d'onde qui est à 30 nm de la deuxième longueur d'onde de pic (λ2) vers l'extrémité de longueur d'onde plus courte.

3. Dispositif électroluminescent (1) selon la revendication 1 ou la revendication 2, dans lequel
la lumière émise depuis le dispositif électroluminescent (1) présente un rapport d'une première distribution spectrale d'un premier spectre d'émission dans la région de longueurs d'onde de 630 à 680 nm à une distribution spectrale d'émission d'un spectre d'émission dans une région de longueurs d'onde de 350 à 800 nm étant de 3 à 10 %.

4. Dispositif électroluminescent (1) selon l'une quelconque des revendications 1 à 3, dans lequel
la lumière émise depuis le dispositif électroluminescent (1) présente un rapport d'une deuxième distribution spectrale d'un deuxième spectre d'émission dans la région de longueurs d'onde de 430 à 480 nm à une distribution spectrale d'émission d'un spectre d'émission dans une région de longueurs d'onde de 350 à 800 nm étant de 40 à 50 %.

5. Dispositif électroluminescent (1) selon l'une quelconque des revendications 1 à 4, dans lequel
la lumière émise depuis le dispositif électroluminescent (1) présente en outre une quatrième longueur d'onde de pic (λ4) dans une région de longueurs d'onde de 680 à 710 nm, et
la lumière émise depuis le dispositif électroluminescent (1) a, par rapport à une intensité de lumière de la lumière émise depuis le dispositif électroluminescent (1) à la deuxième longueur d'onde de pic (λ2) étant 1, une intensité de lumière relative de 0,05 à 0,35 à la quatrième longueur d'onde de pic (λ4).

6. Dispositif électroluminescent (1) selon la revendication 5, dans lequel
une demi-largeur à la quatrième longueur d'onde de pic (λ4) est un tiers ou moins d'une demi-largeur à la première longueur d'onde de pic (A1).

7. Dispositif électroluminescent (1) selon la revendication 5 ou la revendication 6, dans lequel
une intensité de lumière relative à la quatrième longueur d'onde de pic (λ4) est 0,7 ou plus par rapport à une intensité de lumière relative à la première longueur d'onde de pic (λ1).

8. Dispositif électroluminescent (1) selon l'une quelconque des revendications 1 à 7, dans lequel
la lumière émise depuis le dispositif électroluminescent (1) présente un rapport d'une troisième distribution spectrale d'un spectre d'émission dans la région de longueurs d'onde de 380 à 430 nm à une distribution spectrale d'émission d'un spectre d'émission dans une région de longueurs d'onde de 350 à 800 nm étant de 8 à 10 %.

9. Dispositif électroluminescent (1) selon l'une quelconque des revendications 1 à 8, dans lequel
la lumière émise depuis le dispositif électroluminescent (1) a, par rapport à une intensité de lumière de la lumière émise depuis le dispositif électroluminescent (1) à la deuxième longueur d'onde de pic (λ2) étant 1, une intensité de lumière relative de 0,05 à 0,1 à la première valeur minimale (V1).

10. Dispositif électroluminescent (1) selon l'une quelconque des revendications 1 à 9, dans lequel
la lumière émise depuis le dispositif électroluminescent (1) a une deuxième valeur minimale (V2) d'une intensité de lumière entre la deuxième longueur d'onde de pic (λ2) et la troisième longueur d'onde de pic (λ3), et
la lumière émise depuis le dispositif électroluminescent (1) a, par rapport à une intensité de lumière de la lumière émise depuis le dispositif électroluminescent (1) à la deuxième longueur d'onde de pic (λ2) étant 1, une intensité de lumière relative de 0,1 à 0,2 à la deuxième valeur minimale (V2).

11. Dispositif électroluminescent (1) selon la revendication 10, dans lequel
l'intensité de lumière relative de la lumière émise depuis le dispositif électroluminescent (1) à la deuxième valeur minimale (V2) est supérieure à une intensité de lumière relative à la première valeur minimale (V1).

12. Dispositif électroluminescent (1) selon l'une quelconque des revendications 1 à 11, dans lequel
la lumière émise depuis le dispositif électroluminescent (1) a une intensité de lumière maximale dans une plage de longueurs d'onde de 350 à 800 nm à la deuxième longueur d'onde de pic (λ2).

13. Dispositif électroluminescent (1) selon la revendication 1, dans lequel
la lumière émise depuis le dispositif électroluminescent (1) présente un spectre d'émission asymétrique avec la deuxième longueur d'onde de pic (λ2) à un centre dans une plage de longueurs d'onde de 430 à 550 nm.

14. Dispositif électroluminescent (1) selon l'une quelconque des revendications 1 à 13, dans lequel
la lumière émise depuis le dispositif électroluminescent (1) présente un rapport d'une quatrième distribution spectrale d'un spectre d'émission dans une région de longueurs d'onde de 430 à 550 nm à une distribution spectrale d'émission d'un spectre d'émission dans une région de longueurs d'onde de 350 à 800 nm étant de 65 à 80 %.

15. Appareil d'éclairage (10), comprenant :
un ou plusieurs dispositifs électroluminescents (1) selon l'une quelconque des revendications 1 à 14.

16. Appareil d'éclairage (10) selon la revendication 15, comprenant en outre :
un contrôleur (30) configuré pour ajuster des intensités de lumière dudit un ou desdits plusieurs dispositifs électroluminescents (1).
